# EUROPÄISCHE PATENTANMELDUNG

(11) **EP 2 257 148 A2**
(43) Veröffentlichungstag der Anmeldung: **01.12.2010**
(21) Anmeldenummer: 10162766.9
(22) Anmeldetag: 13.05.2010
(51) Int. Cl.: H05K 9/00

(54) **Gehäuse mit einer Beschichtung**

(30) Priorität: 29.05.2009 DE 102009023191
(71) Anmelder: Fraunhofer-Gesellschaft zur Förderung der angewandten Forschung, 80686 München (DE)
(72) Erfinder: Bandorf, Ralf Dr., 31241 Ilsede (DE); Staperfeld, Georg Dr., 42082 Osnabrück (DE); Sarova, Ginka, 32339 Espelkamp (DE)
(74) Vertreter: Goeden, Christian

(57) **Zusammenfassung**

Die Erfindung betrifft die Verwendung einer Beschichtung zur EMV-Abschirmung mindestens einer Baugruppe und/oder zum Korrosionsschutz, wobei die Beschichtung auf einem Trägermaterial fest-haftend angebracht ist, dadurch ge-kenn-zeichnet, dass die Beschichtung eine Verbindung der Summenformel MqArXs enthält, wobei das Element M ausgewählt ist aus Sc und/oder Ti und/oder V und/oder Cr und/oder Zr und/oder Nb und/oder Mo und/oder Hf und/oder Ta, das Element A ausgewählt ist aus Al und/oder Si und/oder P und/oder S und/oder Ga und/oder Ge und/oder As und/oder Cd und/oder In und/oder Sn und/oder Pb und/oder Tl und das Element X ausgewählt ist aus C und/oder N, wobei die Parameter q, r, s größer eins gewählt sind und die Beschichtung weiterhin ein Nanokomposit enthält, welches zumindest ein Element aus der Verbindung der Summenformel MqArXs enthält. Weiterhin betrifft die Erfindung ein mit der Beschichtung versehenes Gehäuse.

## Beschreibung

### Beschreibung

### Gehäuse mit einer Beschichtung

Die Erfindung betrifft die Verwendung einer Beschichtung zur EMV-Abschirmung mindestens einer Baugruppe und/oder zum Korrosionsschutz, wobei die Beschichtung auf einem Trägermaterial fest haftend angebracht ist, sowie ein mit der Beschichtung versehenes Gehäuse.

Aus der DE 10 2007 001 392 A1 ist bekannt, ein Gehäuse für die Aufnahme elektronischer Bauelemente mit einer Funktionsschicht zur elektromagnetischen Abschirmung zu versehen. Gemäß dem Stand der Technik wird diese Funktionsschicht durch eine Chromatierung ausgebildet. Diese kann gleichzeitig als Korrosionsschutzschicht zum Schutz des Gehäuses verwendet werden. Nachteilig an diesem Stand der Technik ist jedoch die Umweltbelastung durch die zur Chromatierung des Gehäuses verwendete Chromsäure. Weiterhin kann die Chromatierungsschicht kanzerogene Chrom(VI)-haltige Stoffe an die Umgebung abgeben. Weiterhin eignet sich die aus dem Stand der Technik bekannte Chromatierung nicht zur Beschichtung von Kunststoffgehäusen, so dass die elektromagnetische Abschirmung solcher Kunststoffgehäuse durch eine zusätzliche, metallische Gehäusewandung sicher gestellt werden muss.

Die Aufgabe der vorliegenden Erfindung besteht demnach darin, eine Beschichtung zur EMV-Abschirmung und/oder zum Korrosionsschutz bereitzustellen, welche eine verbesserte Umweltverträglichkeit, eine erhöhte Temperaturbeständigkeit und eine universelle Verwendbarkeit auf unterschiedlichen Gehäusematerialien aufweist.

Die Aufgabe wird erfindungsgemäß gelöst durch ein Gehäuse zur Aufnahme mindestens einer Baugruppe, mit einer Gehäusewandung, welche zumindest teilweise mit einer Beschichtung versehen ist, wobei die Beschichtung eine Verbindung der Summenformel M_{q}AᵣXₛ enthält, wobei das Element M ausgewählt ist aus Sc, Ti, V, Cr, Zr, Nb, Mo, Hf und/oder Ta, das Element A ausgewählt ist aus A1, Si, P, S, Ga, Ge, As, Cd, In, Sn, Pb und/oder T1 und das Element X ausgewählt ist aus C und/oder N, wobei die Parameter q, r, s größer eins gewählt sind und die Beschichtung weiterhin ein Nanokomposit enthält, welches zumindest ein Element aus der Verbindung der Summenformel M_{q}AᵣXₛ enthält.

Weiterhin besteht die Lösung der Aufgabe in der Verwendung einer Beschichtung zur EMV-Abschirmung und/oder zum Korrosionsschutz, wobei die Beschichtung auf einem Trägermaterial haftend angebracht ist und eine Verbindung der Summenformel M_{q}AᵣXₛ enthält, wobei das Element M ausgewählt ist aus Sc, Ti, V, Cr, Zr, Nb, Mo, Hf und/oder Ta, das Element A ausgewählt ist aus A1, Si, P, S, Ga, Ge, As, Cd, In, Sn, Pb und/oder T1 und das Element X ausgewählt ist aus C und/oder N, wobei die Parameter q, r, s größer eins gewählt sind und die Beschichtung weiterhin ein Nanokomposit enthält, welches zumindest ein Element aus der Verbindung der Summenformel M_{q}AᵣXₛ enthält.

Das erfindungsgemäß verwendete Beschichtungsmaterial der Summenformel M_{q}AᵣXₛ zeichnet sich dadurch aus, dass die Bindungen innerhalb des Gefüges teilweise metallischen, teilweise ionischen und teilweise kovalenten Charakter aufweisen. Als Folge daraus ergeben sich für die Schichten teilweise metallische und teilweise keramische Eigenschaften. So ist die Beschichtung elektrisch leitfähig, kann die für Metalle charakteristische, hohe Wärmeleitfähigkeit aufweisen und kann duktil sein. Im Gegensatz zu metallischen Schichten oder Kohlenstoffschichten kann die erfindungsgemäß verwendete Beschichtung jedoch eine geringere Dichte, eine größere Härte und/oder eine gesteigerte Oxidationsbeständigkeit aufweisen. Die erfindungsgemäße Beschichtung kann thermisch stabil sein und auch bei Temperaturen über 200°C einsetzbar bleiben. Bevorzugte Ausgestaltungen der Erfindung erlauben den Einsatz der erfindungsgemäßen Beschichtung bei Temperaturen über 400°C

Zur Erhöhung der elektrischen Leitfähigkeit enthält die erfindungsgemäß vorgeschlagene Beschichtung weiterhin ein Nanokomposit, d.h. nanoskalige Füllstoffe mit einer Größe von etwa 0.1 nm bis etwa 1000 nm, bevorzugt von etwa 5 nm bis etwa 500 nm, besonders bevorzugt von etwa 10 nm bis etwa 250 nm. Das Nanokomposit kann dabei aus einem einzelnen Element, einer binären Phase, einer ternären Phase, einer quatenären Phase oder einer Phase noch höherer Ordnung gebildet werden. Das Nanokomposit enthält erfindungsgemäß zumindest ein Element aus der in der jeweiligen Beschichtung verwendeten Verbindung der Summenformel M_{q}AᵣXₛ.

Erfindungsgemäß wird vorgeschlagen, die Beschichtung zumindest als Teilbeschichtung auf der Gehäusewandung eines Gehäuses aufzubringen. Die Gehäusewandung kann beispielsweise aus einem Kunststoffmaterial, einem Metall oder einer Legierung gefertigt sein. Die Beschichtung kann in einigen Ausführungsformen mittels eines Plasmabeschichtungsverfahrens aus einer aktivierten Gasphase aufgebracht werden, beispielsweise mittels chemical vapour deposition oder physical vapour deposition.

Die erfindungsgemäß vorgeschlagene Beschichtung kann dazu vorgesehen sein, bei Betrieb einer im Inneren des Gehäuses angeordneten elektrischen oder elektronischen Baugruppe mit einem vorgebbaren elektrischen Potential beaufschlagt zu werden. In diesem Fall reduziert die Beschichtung als EMV-Abschirmung das Eindringen elektromagnetischer Felder in das Innere des Gehäuses ebenso wie den Austritt von elektromagnetischen Feldern, welche bei Betrieb der Baugruppe entstehen können. Auf diese Weise wird die elektro-magnetische Verträglichkeit der Baugruppe wunschgemäß erhöht.

Weiterhin kann die erfindungsgemäß vorgeschlagene Beschichtung den Korrosionsschutz des Gehäuses sicherstellen oder zumindest verbessern. Auf diese Weise kann die Baugruppe und das diese umgebende Gehäuse in korrosiven Umgebungen, beispielsweise in Kraftfahrzeugen, in Industrieanlagen oder im Einflussbereich von Seewasser eingesetzt werden.

Unter einer Baugruppe im Sinne der vorliegenden Erfindung wird insbesondere eine Flachbaugruppe, d.h. eine mit elektronischen oder elektrischen Bauelementen bestückte Leiterplatte verstanden. Weiterhin kann die Baugruppe zumindest einen Steckverbinder enthalten oder aus einem Steckverbinder bestehen, wobei das Gehäuse zur elektrischen Abschirmung des Steckverbinders verwendbar ist. Die Anwesenheit einer erfindungsgemäßen Beschichtung auf dem Gehäuse eines Steckverbinders schließt nicht aus, dass auch die Kontaktflächen des Steckverbinders mit einer erfindungsgemäßen Beschichtung versehen sind um den Übergangswiderstand zu reduzieren und/oder den Korrosionsschutz zu verbessern.

In einigen Ausführungsformen der Erfindung wird für die Verbindung der Summenformel M_{q}AᵣXₛ der Parameter q zwischen 2 und 4 gewählt, der Parameter r = 1 und der Parameter s = q-1. In einigen Ausführungsformen ist der Parameter q ganzzahlig gewählt. In diesem Fall kann die Beschichtung insbesondere folgende Verbindungen enthalten: Ti₂AlC, Ti₂AlN, Hf₂PbC, Nb₂AlC, (NbTi)₂AlC, Ti₂AlN_{0,5}C_{0.5}, Ti₂GeC, Cr₂SnC, Ta₂GaC, Hf₂SnC, Ti₂SnC, Nb₂SnC, Cr₂PbC, Ti₂PbC, Ti₃AlC₂, Ti₃GeC₂, Ti₃SiC₂, Ti₄AlN₃ und/oder Ti₄SiC₃. In diesem Fall weist die Beschichtung besonders gute mechanische und elektrische Eigenschaften auf.

In einer Weiterbildung der Erfindung kann die Beschichtung zumindest eine erste Schicht mit einer ersten Zusammensetzung und eine zweite Schicht mit einer zweiten Zusammensetzung enthalten, wobei die zweite Schicht auf der Oberfläche der ersten Schicht angeordnet ist. Bei dieser Ausführungsform können positive Eigenschaften einer Mehrzahl von Schichtmaterialien miteinander kombiniert werden. Beispielsweise kann die erste Schicht mit einer ersten Zusammensetzung ein Metall oder eine Legierung enthalten und als Haftvermittlerschicht für die zweite Schicht dienen, welche die erfindungsgemäß vorgeschlagene Zusammensetzung aus einer Verbindung der Summenformel M_{q}AᵣXₛ und einem Nanokomposit aufweist.

Weiterhin kann vorgesehen sein, dass die erste Schicht die erfindungsgemäß vorgeschlagene Zusammensetzung aus einem Nanokomposit und einer Verbindung der Summenformel M_{q}AᵣXₛ enthält und die zweite Schicht dazu vorgesehen ist, die Oberflächeneigenschaften der ersten Schicht zu verändern. Beispielsweise kann die zweite Schicht eine geringere elektrische Leitfähigkeit aufweisen als die erste Schicht. In diesem Fall kann die zweite Schicht dazu verwendet werden, elektrische Kurzschlüsse auf der Baugruppe zu verhindern, falls diese die Gehäusewandung berührt. In diesem Fall enthält die zweite Schicht insbesondere ein Oxid oder ein Nitrid oder ein Oxinitrid. In besonders einfacher Weise kann ein solches Oxid ausgebildet werden, wenn das Element A der Verbindung der Summenformel M_{q}AᵣXₛ Silizium ist.

In einer anderen Ausführungsform der Erfindung kann die zweite Schicht eine größere elektrische Leitfähigkeit aufweisen als die erste Schicht. Dies kann der Verbesserung der Abschirmwirkung dienen. In einigen Ausführungsformen enthält die zweite Schicht hierzu ein Metall oder eine Legierung, insbesondere Gold, Silber, Palladium, Platin, Rhodium, Iridium, Rhenium, Molybdän, Wolfram und/oder Nickel.

In weiteren Ausführungsformen der Erfindung kann die Beschichtung schließlich auch aus mehr als zwei Schichten bestehen, beispielsweise einer Haftvermittlerschicht, einer Schicht, welche eine Verbindung der Summenformel M_{q}AᵣXₛ und einem Nanokomposit enthält und eine Oxidschicht. Zwischen den einzelnen Schichten kann ein scharfer Übergang vorgesehen sein, d.h. die Schichtmaterialien wechseln innerhalb weniger Atomlagen oder ein gradierter Übergang, d.h. das eine Schichtmaterial geht allmählich in das andere Schichtmaterial über. Ein solcher allmählicher Übergang kann in einigen Ausführungsformen der Erfindung über einige Nanometer, beispielsweise 2 - 100 nm, erfolgen.

In einigen Ausführungsformen der Erfindung kann die Beschichtung eine periodische Struktur aufweisen. Zwischen einzelnen Schichten der Beschichtung kann ein abrupter Übergang vorgesehen sein oder ein kontinuierlicher Übergang mit einer Mischzone, in welcher ein erstes Schichtmaterial mit einer ersten Zusammensetzung allmählich in ein zweites Schichtmaterial mit einer zweiten Zusammensetzung übergeht. Die Anzahl der Einzelschichten der periodischen Struktur kann zwischen 4 und etwa 100 liegen. Insbesondere liegt die Anzahl der Einzelschichten zwischen etwa 20 und etwa 50.

Nachfolgend soll die Erfindung anhand von Figuren und Ausführungsbeispielen ohne Beschränkung des allgemeinen Erfindungsgedankens näher erläutert werden. Dabei zeigt:
Figur 1 einen Querschnitt durch ein erfindungsgemäßes Gehäuse zur Aufnahme einer Baugruppe.
Figur 2 zeigt einen erfindungsgemäß hergestellten elektrischen Steckverbinder.
Figur 3 zeigt schematisch den Aufbau einer erfindungsgemäßen Beschichtung.

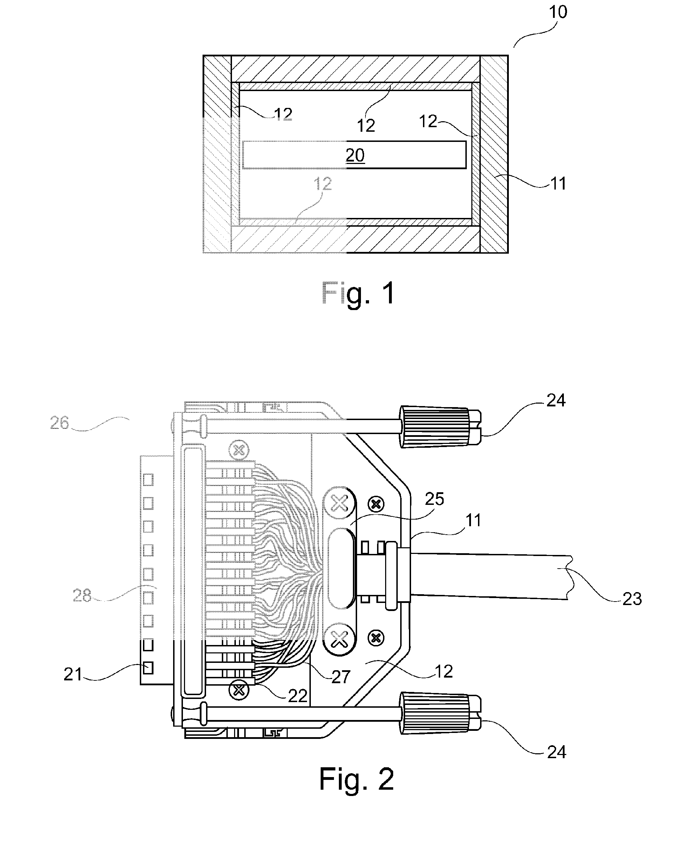

Figur 1 zeigt einen Querschnitt durch ein erfindungsgemäß vorgeschlagenes Gehäuse 10 zur Aufnahme mindestens einer Baugruppe 20. Die Baugruppe 20 kann beispielsweise eine Flachbaugruppe sein, d. h. eine Platine aus einem isolierenden Material, auf welchem elektrische Leiterbahnen fest haftend angebracht sind. Weiterhin trägt die Platine elektrische bzw. elektronische Bauelemente, wie beispielsweise Widerstände, Kondensatoren, Induktivitäten oder Halbleiterbauelemente, welche mittels der Leiterbahnen miteinander elektrisch kontaktiert sind. Die Baugruppe 20 kann bei ihrem Betrieb elektromagnetische Wellen erzeugen, welche von der Baugruppe 20 in die Umgebung ausgesendet werden und in der Nähe der Baugruppe befindliche, weitere Baugruppen stören können. Gleichzeitig können von weiteren, nicht dargestellten Baugruppen elektro-magnetische Störungen erzeugt werden, welche ihrerseits die Funktion der Baugruppe 20 beeinträchtigen können.

Zur Erhöhung der elektromagnetischen Verträglichkeit der Baugruppe 20 ist eine elektrisch leitfähige Beschichtung 12 vorgesehen, welche mittels eines Kontaktelementes kontaktierbar ist und auf einem vorgebbaren Potential gehalten werden kann. Insbesondere eignet sich hierzu ein Erd- oder Nullpotential. Auf diese Weise bildet sich im Inneren des Gehäuses 10 ein Faraday'scher Käfig aus, welcher frei von äußeren elektromagnetischen Feldern ist. Weiterhin können im Inneren des Gehäuses 10 erzeugte elektromagnetische Felder das Gehäuse 10 nicht mehr oder nur abgeschwächt verlassen.

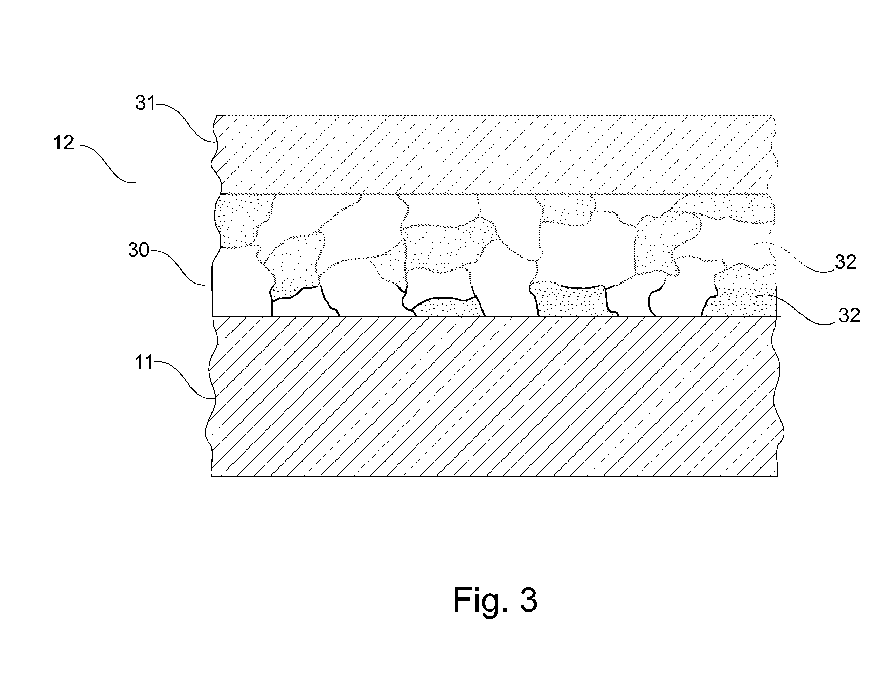

Die Beschichtung 12 enthält das erfindungsgemäß vorgeschlagene Nanokomposit, welches zumindest eine Verbindung der Summenformel M_{q}AᵣXₛ enthält, wobei das Element M ausgewählt ist aus Sc, Ti, V, Cr, Zr, Nb, Mo, Hf und/oder Ta, das Element A ausgewählt ist aus A1, Si, P, S, Ga, Ge, As, Cd, In, Sn, Pb und/oder T1 und das Element X ausgewählt ist aus C und/oder N. Das Nanokomposit enthält somit im Wesentlichen ein Karbid oder ein Nitrid aus einem Übergangsmetall oder einer Kombination von Übergangsmetallen und einem Element der vierten Hauptgruppe des Periodensystems. Weiterhin enthält das Nanokomposit in einigen Ausführungsformen der Erfindung zumindest zwei Phasen mit der Zusammensetzung MA, AX, MAX, X oder MX. Das Nanokomposit kann in Abhängigkeit der gewählten Zusammensetzung metallische und/oder keramische Materialeigenschaften aufweisen, wobei die Schichtstruktur auf mikroskopischer Skala nicht homogen ist. Vielmehr weist die Schicht nanoskalige Füllkörper auf, wie in Zusammenhang mit Figur 3 näher erläutert wird.

Die erfindungsgemäß vorgeschlagene Beschichtung 12 kann beispielsweise aus einer aktivierten Gasphase abgeschieden werden. Insbesondere eignet sich hierzu eine Chemical Vapour Deposition oder eine Physical Vapour Deposition.

Die erfindungsgemäß vorgeschlagene Beschichtung (12) kann in einigen Ausführungsformen eine Dicke von etwa 0.1 µm bis etwa 10 µm aufweisen, insbesondere etwa 0.5 µm bis etwa 1 µm. Eine solche Beschichtung kann bereits ausreichen, um die elektro-magnetische Verträglichkeit der Baugruppe zu erhöhen und ist andrerseits dünn genug, um die Maßhaltigkeit der Gehäusebauteile nicht zu verschlechtern, so dass große Spaltmaße an den Fügestellen vermieden werden. Durch solche Spalte können sich die EMV-Eigenschaften wieder verschlechtern.

Die Beschichtung 12 ist zumindest als Teilbeschichtung der Gehäusewandung 11 des Gehäuses 10 ausgeführt. Beispielsweise kann die Beschichtung 12 eine Strukturierung in Form eines Gitters aufweisen, wobei die elektromagnetische Abschirmung für Wellenlängen größer als die Maschenweite des Gitters erhalten bleibt. Die Teilbeschichtung kann so ausgeführt ein, dass ein elektrischer Kontakt zwischen einzelnen Teilflächen der Beschichtung erhalten bleibt, beispielsweise zwischen einzelnen Teilflächen, welche auf unterschiedlichen Gehäusewandungen bzw. unterschiedlichen Gehäuseteilen aufgebracht sind.

Die Beschichtung 12 kann entweder, wie in Figur 1 dargestellt, auf der Innenseite der Gehäusewandungen 11 aufgebracht sein und/oder auf der Außenseite der Gehäusewandung 11. Die Gehäusewandung 11 kann beispielsweise aus einem Metall, einer Legierung oder einem Kunststoff hergestellt sein. Insbesondere eignet sich für die Herstellung der Gehäusewandung 11 eine Aluminiumlegierung.

Figur 2 zeigt einen Steckverbinder als spezielle Ausführungsform der vorliegenden Erfindung. Der Steckverbinder 26 weist ein Kontaktelement 21 auf, welches eine Mehrzahl von Steckkontakten und/oder Buchsenkontakten aufweist. Die Steckkontakte und/oder Buchsenkontakte sind von der in Figur sichtbaren Abschirmung 28 verdeckt und daher in Figur 2 nicht dargestellt. Die Stiftkontakte und/oder Buchsenkontakte weisen rückwärtig jeweils einen zugeordneten Kabelanschluss 22 auf, welcher beispielsweise durch Löten oder Crimpen mit einer einzelnen Ader eines mehradrigen Anschlusskabels 23 verbunden ist.

Das Anschlusskabel 23 enthält eine Mehrzahl von Adern 27, welche jeweils zur Übertragung eines einzelnen Signals vorgesehen sind sowie eine gemeinsame Abschirmung, welche alle Adern 27 in Form eines Geflechtes umgibt. Das Anschlusskabel 23 ist in das Gehäuse 11 des Steckverbinders 26 eingeführt und dort mittels einer Zugentlastung 25 gesichert.

Das Gehäuse 11 weist weiterhin zwei Befestigungsvorrichtungen 24 auf, mit welchen der Steckverbinder 26 an einem korrespondierenden Steckverbinder mechanisch fixiert werden kann.

Um die Einstreuung elektromagnetischer Störsignale in die Adern 27 im Bereich der Anschlusskontakte 22 zu verhindern, ist das Gehäuse 11 an seiner Innenseite und/oder an seiner Außenseite mit einer erfindungsgemäßen Beschichtung 12 versehen. Auf diese Weise wird der durch die Geflechtabschirmung im Inneren des Kabels 23 gebildete Faraday'sche Käfig auch im Inneren des Gehäuses 11 des Steckverbinders 26 fortgesetzt und die elektromagnetische Verträglichkeit des Steckverbinders 26 erhöht.

Es ist darauf hinzuweisen, dass die in Figur 2 dargestellte Geometrie des Steckverbinders 26 lediglich beispielhaft zu sehen ist. Selbstverständlich kann die erfindungsgemäße Beschichtung 12 auch in anderen Steckverbindern 26 bzw. deren Gehäuse 11 eingesetzt werden. Insbesondere eignet sich die vorgeschlagene Beschichtung für Koaxialsteckverbinder.

Figur 3 zeigt eine schematische Darstellung der mikroskopischen Struktur der Beschichtung 12. Hierzu zeigt Figur 3 einen Ausschnitt aus dem Querschnitt durch eine Gehäusewandung 11 mit einer darauf angebrachten Beschichtung 12. Die Gehäusewandung 11 kann beispielsweise aus einem Metall oder einer Legierung hergestellt sein. In anderen Ausführungsformen der Erfindung kann die Gehäusewandung 11 aus einem Kunststoffmaterial bestehen. Entweder auf der Innenseite oder auf der Außenseite der Gehäusewandung 11, fallweise auch beidseitig, ist die Beschichtung 12 aufgebracht. In Figur 3 umfasst die Beschichtung 12 eine erste Schicht 30 mit einer ersten Zusammensetzung und eine zweite Schicht 31 mit einer zweiten Zusammensetzung. Selbstverständlich kann die Beschichtung 12 jedoch auch aus einer größeren Anzahl von Einzelschichten oder einer geringeren Anzahl von Einzelschichten bestehen. Insbesondere ist die zweite Schicht 31 optional und kann in anderen Ausführungsformen der Erfindung entfallen.

Die erste Schicht 30 umfasst ein Nanokomposit, d.h. die Schicht ist aus unterschiedlichen Kristalliten mit dazwischen liegenden Korngrenzen zusammengesetzt. Beispielhaft sind in Figur 3 zwei Phasen 32 und 33 unterschiedlicher chemischer Zusammensetzung dargestellt. Selbstverständlich können in weiteren Ausführungsformen der Erfindung auch drei oder mehr unterschiedliche Phasen in der Schicht 30 vorhanden sein.

Die Phase 33 enthält dabei die chemische Verbindung der Summenformel M_{q}AᵣXₛ wie vorstehend beschrieben. Beispielsweise kann die Phase 33 Ti₃SiC₂ enthalten bzw. aus diesem Material bestehen. Dem Fachmann ist dabei selbstverständlich geläufig, dass die Phase 33 daneben weitere Elemente enthalten kann, insbesondere unvermeidbare Verunreinigungen oder Dotierstoffe, welche beim Herstellungsprozess der Schicht 30 in diese eingebaut werden.

Die Phase 33 bildet einen nanokristallinen Füllstoff für die Phase 32, welche zumindest eine Verbindung aus den Elementen MA, AX, MAX, X oder MX enthält. Im vorstehend beschriebenen Ausführungsbeispiel kann die Phase 32 insbesondere TiC, SiC, TiSiC, TiSi oder C enthalten. Fallweise kann die Phase 32 auch mehrere der genannten Verbindungen enthalten. Die Phase 32 kann amorph oder kristallin sein. Insbesondere kann die Phase 32 ihrerseits wieder eine Mischkristallphase sein, welche sowohl amorphe als auch nanokristalline Bereiche umfasst.

Die jeweilige Zusammensetzung der Schicht 30 kann in unterschiedlichen Ausführungsformen der Erfindung variieren, wobei nicht alle genannten Phasen notwendigerweise in jeder Ausführungsform vorhanden sind.

Die Schicht 30 weist die für eine hinreichende Abschirmung bzw. Schwächung elektromagnetischer Felder notwendige Leitfähigkeit auf. Auf der Schicht 30 ist im dargestellten Ausführungsbeispiel eine weitere Schicht 31 angeordnet. Die Schicht 31 kann dabei die Oberflächeneigenschaften der Schicht 30 modifizieren. Beispielsweise kann die Schicht 31 eine Schicht mit geringerer Leitfähigkeit sein als die Schicht 30. Auf diese Weise kann die Ausbildung von Kurzschlüssen in der Baugruppe 20 verhindert werden, falls die Baugruppe 20 die Oberfläche der Beschichtung 12 berührt. Für eine isolierende Schicht 31 eignet sich insbesondere eine Schicht, welche ein Oxid, ein Nitrid oder ein Oxinitrid enthält. Insbesondere kann die Schicht 31 SiₓO_{y}, SiₓN_{y} und/oder SiₓO_{y}N_{z} enthalten. Eine solche Schicht 31 kann beispielsweise durch eine thermische Behandlung in einer O₂- oder N₂-haltigen Gasatmosphäre erzeugt werden, wenn die Schicht 30 Silizium enthält.

In anderen Ausführungsformen der Erfindung kann auch vorgesehen sein, dass die Schicht 31 eine größere Leitfähigkeit aufweist als die Schicht 30. In diesem Fall kann die Schicht 31 die Abschwächung bzw. Abschirmwirkung elektromagnetischer Felder weiter verbessern. Die Schicht 31 enthält dabei in einigen Ausführungsformen Gold, Silber, Palladium, Platin, Rhodium, Iridium, Rhenium, Molybdän, Wolfram, Nickel oder eine Legierung zumindest eines dieser Elemente.

In wiederum einer anderen Ausführungsform der Erfindung kann die Schicht 31 auch einen ähnlichen Aufbau wie die Schicht 30 aufweisen, wobei die unterschiedlichen Phasen 32 und 33 des Nanokomposits andere chemische Zusammensetzungen aufweisen.

Dem Fachmann ist selbstverständlich geläufig, dass die Erfindung nicht auf die dargestellten Ausführungsbeispiele beschränkt ist. Vielmehr erlaubt die Erfindung im Rahmen der Offenbarung Modifikationen und Änderungen, ohne den allgemeinen Erfindungsgedanken zu verlassen.

## Patentansprüche

1. Gehäuse (10) zur Aufnahme mindestens einer Baugruppe (20), mit einer Gehäusewandung (11), welche zumindest teilweise mit einer Beschichtung (12) versehen ist, **dadurch gekennzeichnet, dass** die Beschichtung zumindest eine Verbindung (33) der Summenformel M_{q}AᵣXₛ enthält, wobei das Element M ausgewählt ist aus Sc und/oder Ti und/oder V und/oder Cr und/oder Zr und/oder Nb und/oder Mo und/oder Hf und/oder Ta, das Element A ausgewählt ist aus Al und/oder Si und/oder P und/oder S und/oder Ga und/oder Ge und/oder As und/oder Cd und/oder In und/oder Sn und/oder Pb und/oder T1 und das Element X ausgewählt ist aus C und/oder N, wobei die Parameter q, r, s größer eins gewählt sind und die Beschichtung (12) weiterhin ein Nanokomposit (32) enthält, welches zumindest ein Element aus der Verbindung der Summenformel M_{q}AᵣXₛ enthält.

2. Gehäuse nach Anspruch 1, **dadurch gekennzeichnet, dass** für die Verbindung (33) der Summenformel M_{q}AᵣXₛ der Parameter q zwischen 2 und 4 gewählt ist, der Parameter r = 1 ist und der Parameter s = q-1 ist.

3. Gehäuse nach einem der Ansprüche 1 oder 2, **dadurch gekennzeichnet, dass** die Baugruppe (20) eine Flachbaugruppe und/oder einen Steckverbinder (21) enthält.

4. Gehäuse nach einem der Ansprüche 1 bis 3, **dadurch gekennzeichnet, dass** die Beschichtung (12) zumindest eine erste Schicht (30) mit einer ersten Zusammensetzung und eine zweite Schicht (31) mit einer zweiten Zusammensetzung enthält, wobei die zweite Schicht (31) auf der Oberfläche der ersten Schicht (30) angeordnet ist.

5. Gehäuse nach Anspruch 4, **dadurch gekennzeichnet, dass** die zweite Schicht (31) eine geringere elektrische Leitfähigkeit aufweist als die erste Schicht (30).

6. Gehäuse nach einem der Ansprüche 4 oder 5, **dadurch gekennzeichnet, dass** die zweite Schicht (31) ein Oxid und/oder ein Nitrid und/oder ein Oxinitrid enthält.

7. Gehäuse nach einem der Ansprüche 4 bis 6, **dadurch gekennzeichnet, dass** die zweite Schicht (31) nur eine Teilfläche der ersten Schicht (30) bedeckt.

8. Gehäuse nach einem der Ansprüche 1 bis 7, **dadurch gekennzeichnet, dass** das Nanokomposit (32) zumindest eine amorphe und/oder zumindest eine kristalline Phase enthält.

9. Gehäuse nach einem der Ansprüche 1 bis 8, **dadurch gekennzeichnet, dass** das Nanokomposit (32) zumindest zwei unterschiedliche Verbindungen der Elemente MA und/oder AX und/oder MAX und/oder X und/oder MX enthält.

10. Elektrischer Steckverbinder (21) mit einem Gehäuse (10) nach einem der Ansprüche 1 bis 9.

11. Verwendung einer Beschichtung (12) zur EMV-Abschirmung mindestens einer Baugruppe (20) und/oder zum Korrosionsschutz, wobei die Beschichtung (12) auf einem Trägermaterial (11) festhaftend angebracht ist, **dadurch gekennzeichnet, dass** die Beschichtung (12) zumindest eine Verbindung (33) der Summenformel M_{q}AᵣXₛ enthält, wobei das Element M ausgewählt ist aus Sc und/oder Ti und/oder V und/oder Cr und/oder Zr und/oder Nb und/oder Mo und/oder Hf und/oder Ta, das Element A ausgewählt ist aus A1 und/oder Si und/oder P und/oder S und/oder Ga und/oder Ge und/oder As und/oder Cd und/oder In und/oder Sn und/oder Pb und/oder T1 und das Element X ausgewählt ist aus C und/oder N, wobei die Parameter q, r, s größer eins gewählt sind und die Beschichtung weiterhin ein Nanokomposit (32) enthält, welches zumindest ein Element aus der Verbindung der Summenformel M_{q}AᵣXₛ enthält.

12. Verwendung nach Anspruch 11, **dadurch gekennzeichnet, dass** für die Verbindung (33) der Summenformel M_{q}AᵣXₛ der Parameter q zwischen 2 und 4 gewählt ist, der Parameter r = 1 ist und der Parameter s = q-1 ist.

13. Verwendung nach einem der Ansprüche 11 oder 12, **dadurch gekennzeichnet, dass** die Beschichtung (12) zumindest eine erste Schicht (30) mit einer ersten Zusammensetzung und eine zweite Schicht (31) mit einer zweiten Zusammensetzung enthält, wobei die zweite Schicht (31) zumindest als Teilbeschichtung auf der Oberfläche der ersten Schicht (30) angeordnet ist.

14. Verwendung nach Anspruch 13, **dadurch gekennzeichnet, dass** die zweite Schicht (31) eine geringere elektrische Leitfähigkeit aufweist als die erste Schicht (30).

15. Verwendung nach einem der Ansprüche 11 bis 14,
**dadurch gekennzeichnet, dass** das Nanokomposit (32) zumindest zwei unterschiedliche Verbindungen der Elemente MA und/oder AX und/oder MAX und/oder X und/oder MX enthält.
